# EUROPEAN PATENT APPLICATION

(11) **EP 2 269 561 A1**
(43) Date of publication of application: **05.01.2011**
(21) Application number: 10185222.6
(22) Date of filing: 01.09.2006
(51) Int. Cl.: A61J 7/04

(54) **Blister pack with content monitoring system (OtCM) based on printed polymer electronics**

(30) Priority: 02.09.2005 NL 1029869
(62) Divisional of application: 06783902.7
(71) Applicant: DSM IP Assets B.V., 6411 TE Heerlen (NL)
(72) Inventor: Geboers, Josephus Antonius, 5552 MA Valkenswaard (NL)
(74) Representative: van Westenbrugge, Andries

(57) **Abstract**

The invention relates to a method and device for the objective measurement of the therapy compliance of patients who are undergoing prescribed medication therapy. The medication is provided in blister packages upon which a polymer-based electronic circuit is printed directly on the blister film (2) or foil (1), using so-called intelligent system-in-foil or system-on-foil technology. In a first embodiment of the invention, the printed polymer circuit comprises a number of conductive tracks (3), which run under each blister so that when a pill is expelled from the blister breaking the foil seal, the corresponding track is broken. These tracks are connected to a silicon or printed polymer integrated circuit (6) that records the event when a track is broken and stores this information, including the time of the event and the position of the blister and any other clinically relevant data. In a second embodiment of the invention, a polymer or electret microphone (11) is used to detect the sound that is generated when a pill is expelled from a blister, breaking the foil seal in the process. In this embodiment, the microphone is connected to a silicon or printed polymer integrated circuit (12) that records the event when the seal is broken and stores this information, including the time of the event and the position of the blister and any other clinically relevant data. The electronic circuit also contains RFID (Radio Frequency IDentification) technology to enable the information stored in the integrated circuit to be accessed using an RFID reader. Furthermore, the integrated circuit of both embodiments can be programmed using the RFID interface during the blister-filling phase with information about the filling medication, including unique codes to counteract counterfeiting, and logistical data. The circuit further comprises an antenna (10) and a power source (9), both of which can be printed during the same, or a separate, system-in-foil and/or system-on-foil process or mounted as discrete components. The intelligent system-in-foil or system-on-foil in accordance with the invention replaces the standard film or foil currently used in the existing standard blister packaging manufacturing process.

## Description

This invention relates to an Objective therapy Compliance Measurement (OtCM) system that is Incorporated in standard blister packs of, in particular, medication and is realised by means of electronic circuitry that is printed using polymer printing techniques.

### BACKGROUND OF THE INVENTION

Patient compliance is crucial for maximum efficacy of any medical therapy. However some patients can get lost in the jungle of medication that they must take for various conditions and others may have difficulty in following their doctor's instructions for correct usage. This may lead to possibly life threatening situations when patients forget to take their pills or take the wrong pill at the wrong time. The costs, in terms of both human suffering and money, are enormous.

The fact that it's a great advantage to signal that there is a deviation from the medication programme on time, is clear when considering an unnecessary long sickness occasionally even fatal as well as the high costs of erroneously too late, too early, chaotic or wrongly with respect to of the prescribed medication program, taken drugs. For The Netherlands in 2004 this financial loss has been estimated being at least € 4,300,000,000 and for the United States at $ 77,000,000,000. That a relatively inexpensive warning and monitoring method can be included in the packaging of the medication, in particular for medication such as contraceptives, anti-depressants, cholesterolemia medication, antibiotics, immune-suppressants and diabetes medication, etc. The practical advantages are; For the patients : improved effectiveness of the medicinal therapy, better information about the health risks, better health; lower costs due to the inexpensive packaging and avoiding of unnecessary change of medication and dumping of original correct drugs. For doctors and pharmacists: Objective and specific personal details about therapy compliance, no reason to change therapy due to misinformation and avoiding dangerous (terminally) complications by HIV, heart failures, asthma, epilepsy. For the pharmaceutical industry: More objective eligibility criteria, better quality data during clinical research, less switching between different medications because of the inefficacy of "good" medications due to therapy non-compliance;
For insurers: less claims for medical costs, less sick days, prevention of "thrash medication" and the associated expenses, lower absenteeism due to sickness, improved insight into the effect of medicinal therapy.

The solution to this problem may be found in the use of an electronic system that monitors the intake of medicine and crosschecks this with patient information that is stored in a database. Such a system needs to be able to read the information from the user's medication package and transmit this to a database no matter where the patient is located.

### SUMMARY OF THE INVENTION

The invention relates to a method and device for the objective measurement of the therapy compliance of patients who are undergoing prescribed medication therapy. The medication is provided in blister packages upon which a polymer-based electronic circuit is printed directly on the blister film or foil, using so-called intelligent system-in-foil or system-on-foil technology. In a first embodiment of the invention, the printed polymer circuit comprises a number of conductive tracks, which run under each blister so that when a pill is expelled from the blister breaking the foil seal, the corresponding track is broken. These tracks are connected to a silicon or printed polymer integrated circuit that records the event when a track is broken and stores this information, including the time of the event and the position of the blister and any other clinically relevant data. In a second embodiment of the invention, a polymer or electret microphone is used to detect the sound that is generated when a pill is expelled from a blister, breaking the foil seal in the process. In this embodiment, the microphone is connected to a silicon or printed polymer integrated circuit that records the event when the seal is broken and stores this information, including the time of the event and the position of the blister and any other clinically relevant data. The electronic circuit also contains RFID (Radio Frequency IDentification) technology to enable the information stored in the integrated circuit to be accessed using an RFID reader. Furthermore, the integrated circuit of both embodiments can be programmed using the RFID interface during the blister filling phase with Information about the filling medication, including unique codes to counteract counterfeiting, and logistical data. The circuit further comprises an antenna and a power source, both of which can be printed during the same, or a separate, system-in-foil and/or system-on-foil process or mounted as discrete components.

The intelligent system-in-foil or system-on-foil in accordance with the invention replaces the standard film or foil currently used in the existing standard blister packaging manufacturing process.

### BRIEF DESCRIPTION OF THE DRAWINGS

Figure 1 illustrates a normal medicine blister pack where (1) is the carrier in most cases aluminium foil, covering the film (2) material containing the compartments (4) and the openings (5) for the pills (7).
Figure 2 shows the printed material on the carrier (1), including conductive polymer tracks (3), a printed or mounted power source (9), a printed or mounted antenna (10) and a dedicated polymer or silicon IC (6).
Figures 3 and 4 illustrate the second embodiment of the invention where the conductive tracks are replaced by a microphone (11) embedded in the film (2) picking-up vibrations via the conduits (13) formed in the film (2) material and fed to the dedicated IC (12) supplied by the printed or mounted power source (9) on the same carrier as the antenna (10).
Figure 5 illustrates the possible system-in-foil option where the printed and mounted material is covered by an additional foil (8), which can be realised for both embodiments of the invention.

### DETAILED DESCRIPTION OF THE PREFERRED EMBODIMENTS

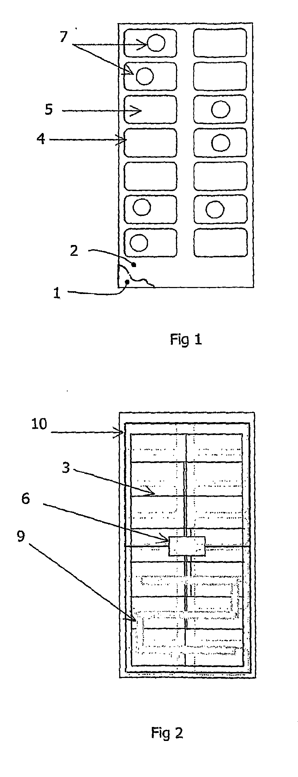

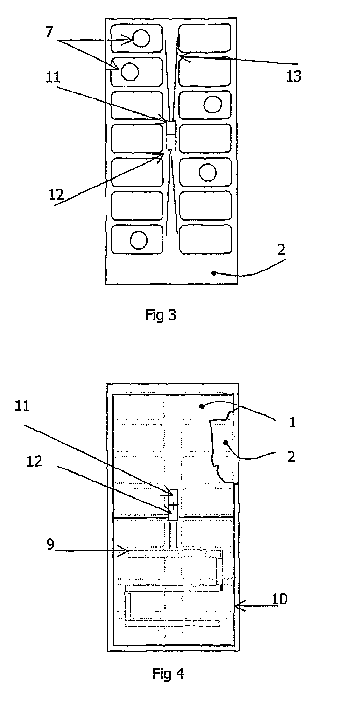

The invention relates to a method for monitoring at least one product, from a series of products for example, each of which is located at a pre-defined location, whereby when an article is removed from one of the pre-defined locations a signal is emitted, which signal is transmitted to a sensor, which contains or is connected to a signal processor such as an Integrated Circuit, in which the signal is measured and the measurement result is compared with the standard values for each of the circumstances that are stored in the IC such as the magnitude of the measurement result; period of time between successive measurements, and the like, whereby in the event that the standard value is exceeded by more than the permitted deviation a specific control code is generated which can be converted into an associated message for a display, radio transmitter or control memory, that can have contacts for making contact with a reader for reading and storing the data from the control memory which control code can also operate a switch of a sound and/or light source and/or of a radio control signal, which radio message or display message can be consulted by an observer immediately or later in order to determine the location, respectively presence or absence and preferably also the identity and the instantaneous quality and temperature of each product. It is further proposed that the control signal is linked with a display remotely via for example an antenna or by a "reader" that contains a remotely readable RFID (Radio Frequency IDentification) detector, that can display data from the control memory or transfer it to a databank, that is consulted by the observer for assessing the period of time between successive measurements respectively presence or absence and/or identity of each product. It is further proposed that the Integrated Circuit used in either or both embodiments of the invention is programmed using a unique algorithm, during or after the blister manufacturing process with unique identification codes, production parameters such as date and time, permitted storage temperature range, medication type, medication classification, expiration date and the like, for anti-counterfeiting and logistical purposes, as well as other clinically relevant data for the use of physicians and pharmacists. Furthermore the invention also relates to a device for carrying out the method In accordance with the invention and a method for manufacturing the device. Similar methods and devices are known, such as for example from the international patent applications WO 03/090663, WO 03/055769, the American patent document 4,616,316 and the American patent document 6,628,199, along with which, the article "Electronic Compliance Packaging hits the market" from "Medical device link" of 9 November 2004, can also be mentioned. Of these known methods and devices for carrying out this method and a method for the partial manufacture of this device for the monitoring, and/or identification of at least one of a number of products, of which each product is stored in a specific compartment of a number of compartments, with a frangible track to each of the compartments, the objection is that numerous metal containing components with metal contacts are needed, that are connected to the frame by means of mainly metal contacts to the under layer of the usually sheet like carrier, which conductors usually are formed at least partially from metal, or conductive ink tracks or conductive organic materials printed on a support layer such as foil, which foil is glued to the under layer of the carrier. The manufacture of this device is expensive, and also the components, in particular the battery, are relatively heavy, so that the total package is large and cumbersome. When used for checking the identification, plagiarism or copying of products and in particular for monitoring the removal of medication from the device that is used as packaging for the medication, carrying such a device is objectionable, and in addition the fact that such an expensive package is thrown away after use, in spite of the high price, makes the possible purchase and use of this device problematic for those with less financial means. The invention defines a method and a device that is manufactured in accordance with that method, that removes the aforementioned objections due to the fact In the embodiment of the invention illustrated in figure 4, the sensor contains at least one microphone (11) and that in the event of a deformation or breakage at a location of the compartment, cavity, shell, storage cell or the like, associated with product, a signal is emitted that is transmitted by the microphone (11) to a signal processor, such as an IC (12), which together with at least one microphone, is located on an under layer that is connected with the carrier, whereby the carrier preferably, at least partially, serves on the one hand to emit a signal upon deformation or breakage and on the other as a conductor. The embodiment of the invention illustrated in figures 1 and 2 uses, In addition to, or instead of a microphone, an element that produces an electrical signal, such as a resistor, capacitor or the like, that connects to a conductive circuit (3) in the vicinity of each product, whereby the conductive circuit, that is mainly composed of organic materials such as polymers and preferably also the elements, IC (6) and antenna (10), are printed by means of a suitable printing technique such as a printing method (jet printing) or rotation offset method, in accordance with a prescribed route on a surface such as the fill of the carrier; In this way, a device can be produced simply and cheaply, that is suitable for mass production and general usage.

The printing of electronic circuits using organic materials as such is known from the American patent application 9304 from 2004, in addition to which the American patent application 82525 from 2005 can also be cited. The application of this technology in the aforementioned devices, whereby, in particular medication packages are meant but also can be used to pack and use safely for instance poisonous or other dangerous products, which appears to offer significant advantages. In this context, attention is drawn to report of a lecture in April 2005: "Printed organic electronic devices using high volume printing processes", or the American patent application 225056 from 2004.

Although these publications mention that in the future it may be an option to create and use RFID circuits that are made from organic materials, the specific use of these in devices such as that which is being described in this document is not described. Rather, the use of printing techniques for polymers and components in flat screens is seen as an application area. In the circuit in accordance with this application, a battery, for example, composed of mainly polymer material, for example by means of the application of an electrolytic gel, with sufficient voltage to activate the IC can also be Included in the circuit, which battery as such is known as such from the international patent application WO 024375 from 2005.

In the application of these inexpensive printed components as a package unit with the conductive tracks in the printed pattern, the filling of the package is possible with a simple filler connected to a Personal Computer, programmed to fill the right product in the right space or room of the package. This is of particular importance in the use of medication and especially when several different dosages and/or different medicines are prescribed successively for the patient. However, given that in many areas it is not permitted to include different types of medication in a single blister, up until now the pharmacist or nurse has put the daily medication for each individual patient into a series of compartments in a pill box or the like, by hand. This "people work" can easily lead to human errors when it is busy or when there are insufficient qualified personnel. By using the relatively inexpensive blister packages in accordance with the invention, each package thereof is programmed for each type of medication, a number of blisters with individual characteristics, (colour, large print, audio signal or the like), obviates these human errors. In a further development of the method in accordance with the invention the unique signals and/or a voltage will be emitted when at least one compartment wall is deformed or broken. With this development it is even possible to include a capacitor that is charged up in the element, which, in the event of deformation or breakage supplies enough current to activate the chip, obviating the need for a separate battery. A capacitor made of organic materials is as such already known from the aforementioned American patent application 82525 from 2005. The use of the method in accordance with the invention is particularly suitable for producing a device whereby the carrier consists of a multitude of compartments, whereby within each compartment some type of product can be stored and whereby, by placing a number of different products each in a predestined space or room and by comparing the unique signals, like special frequencies or sound tones or the like of deformation or of the break through of the specific elements, or of the specific walls of each predestined space or room as controlled by a specific hereto loaded program in the IC, which comparison results in operating signals for a sound or light alarm and/or messages or reports on a display and/or audible through radio or mobile telephone or the like and/or registered in the memory of a database; This further developed device is of great importance in particular for patients with conditions whereby the medication must be taken in a strict order and in a short fixed timeframe. In this way, the physician can discover errors in the therapy compliance quickly, so that intervention can take place on time. With a user friendly method in accordance with the invention, a light or sound signal can be emitted if a product is erroneously taken out or when the space wall containing a product that not yet has to be taken out according to the prescription is being deformed or an alarm signal, such as a sound or light flash is generated and/or a message on a display warns the user that he is taking a wrong product and gives an advice to wait for the right time or choose an other product according to the prescription. It is possible by means of a display, that consists of electronic cells that are composed of organic materials, to make it clear to a patient that it is time to take a specific medication, whereby the packaging reacts if the wrong choice is about to be made by accident, so that the patient is prevented from making the mistake.

Packaging for medication for example, whereby a signal is given when it is time to take medication are already known as such from the International patent application WO 73977 from 2003 for example, while electronic monitoring of therapy compliance with the aid of separate signal processing devices and databanks is known from the American patent document 4.178.112 or the American patent document 4.616.316. In none of these known proposals is the use of microphones and/or of electronic systems that are composed of the aforementioned printed polymers known. In a further development of the method, a temperature sensor is added to one or more of the signal sensors such as the microphones too, that monitor the quality of the product in the event that it is sensitive to temperatures that are too high or too low. The sensed under- and overload is detected by the sensor connected to the IC generates an error signal. Further the invention consists of a package whereby at least one element consists of a capacitor that can be charged that is composed of at least two layers of suitable polymers, that when deformed and/or torn generates a current peak with an associated certain magnitude, large enough to activate the elements connected to the chip, and a certain frequency, that indicates the position of the product and whether it is absent or present. Preferably the packaging in accordance with the invention is in the form of a so-called blister pack and the products are medication, whereby the pattern (3) is printed on the foil (1), which foil is used to seal the openings (5) in the compartments (4) that are formed in the film (2) and which contain the medication (7). This packaging is particularly suitable for measuring the therapy compliance of a patient, who is supposed to take medication that has been prescribed by the doctor and/or dispensed by a pharmacist in accordance with a prescribed order and at prescribed time intervals.
Figure 1 illustrates the front side of a blister with compartments (4), which are filled with pills (7) which can be expelled from the blister via openings (5) in the film (2), which openings are sealed with foil (1);
Figure 2 Illustrates the rear side of such a blister pack whereby the foil (1) a pattern of conductive tracks (3) have been printed in such a way that when the pills (7) are expelled via the openings (5) the conductive track under the opening is broken and this break in the conductive track is detected by the Integrated circuit (6);
Figures 3 and 4 respectively illustrate the front and rear sides of a similar blister pack whereby conduits (13) have been formed in the film (2) during the manufacturing process. In this embodiment a microphone (11) is mounted in the film (2) or on the foil (1). When a pill (7) is expelled from the blister via the openings (5) the vibrations are guided by the conduits (13) to the microphone material (11). The microphone (11) is connected to a dedicated IC (12).
Figures 2 and 4 illustrate the use of a printed or mounted power source (9) for supplying the IC and show a printed or mounted antenna (10) for RFID communications.

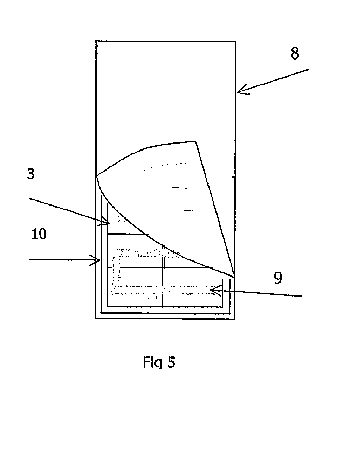

Figure 5 illustrates the option for manufacturing either or both embodiments of the inventions in a system-in-foil process.

In all cases a device is created, whereby in particular the therapy compliance after and even during the medication therapy can be measured accurately and in the event of unacceptable deviation, timely warnings can be given so that Intervention is possible.

## Claims

1. Method for monitoring a removal of at least one product, whereby the at least one product has its own designated location, whereby a signal emitter, that is associated with the or each designated location, is arranged to emit an electric signal under specific conditions, which electrical signal is conducted along conductive tracks to a signal sensor, which conductive tracks are formed by electrically conductive material such as metal tracks or tracks of conductive ink or of conductive polymers , that are printed on a substrate, **characterised in that** the conductive tracks and preferably the signal emitter or an IC, antenna and any other components, are also composed of conductive polymers, that are printed in a defined pattern using a suitable printing technique, such as ink jet printing, on the substrate, such as a carrier or a compartment wall or a layer that is affixed to one of these.

2. Method in accordance with claim 1 for the manufacture of a device, such as an intelligent package, for monitoring the removal of at least one product from a series of products, whereby the signal sensor is sensitive to the electric signals, that are emitted by the signal emitter in the compartment wall under specific circumstances, and are conducted to the signal sensor, from which electric signals, the sensor can determine which compartment emitted the electric signal, **characterised in that** at least the conductive tracks, and preferably the signal sensor are composed of printable conductive polymers, that are printed using standard printing techniques on the substrate that is affixed to the carrier and whereby the signal emitters are part of the conductive tracks that are printed on the substrate in a vicinity of a frangible compartment opening.

3. Method in accordance with claim 1 **characterised in that** the conductive tracks are printed in the defined pattern on the substrate, such as a sealing foil of the carrier, and the components, that are composed mainly of polymer materials but also may use other materials, are mounted separately, whereby the components make contact with the conductive tracks by means of contact bulbs on the components and contact pads on the conductive tracks.

4. Method in accordance with one of the claims 1 to 3, **characterised in that** the electrical signals are emitted when the at least one compartment wall, product encapsulation or the like, is deformed or broken, whereby the signal emitter is incorporated in the compartment wall or the material of the compartment wall itself functions as the signal emitter.

5. Method for the application of the device in accordance with the method described in one or more of the claims 1 to 4, whereby the carrier supports multiple walled spaces or compartments, **characterised in that** by placing a number of different products, each in a designated space or compartment, and by comparing the electric signals, emitted in the event of deformation or breakage of the compartment walls of each designated location as determined by an application program in the IC, which comparison results in operating signals for a sound or light alarm and/or messages or reports for display and/or audible signals for radio or telephone transmission or the like and/or data that is transmitted for storage in a database.

6. Method according to one or more of the preceding claims **characterised in that**, when an erroneous action occurs when removing the product, for instance in the choice of the product, or in the time at which the action occurs with respect to the pre-programmed time interval between two actions, a light or acoustic error signal is given and/or an error message is displayed on a device and/or a radio message is transmitted, for example in the form of an SMS, listing the error and advising the user, for example, to make another product choice or how to act in the event that the action is too early or too late.

7. Method according to one or more of the preceding claims **characterised in that** the filling of the compartments in the device with different products is accomplished by a filling machine or robot in accordance with a particular program and following the pattern as described in one or more of the preceding claims, printed in ink or the like, on the carrier the details of which are stored in the IC on the carrier.

8. Method according to one or more of the preceding claims **characterised in that** the temperature of the compartments is measured by means of a temperature sensor that is composed mainly of polymer materials, but also may use other materials and, in the event of deviations from the pre-set temperature, an error signal is generated, that is processed by the IC to generate an error message or set off one or more alarms or the like.

9. Package for storage of at least one product, whereby the at least one product has its own designated location, whereby a signal emitter that is associated with each designated location, is arranged to emit an electric signal under specific conditions, which electrical signal is conducted along conductive tracks to a sensor, which conductive tracks are formed by electrically conductive material such as metal tracks or tracks of conductive ink or of conductive polymers , that are printed on a substrate, **characterised in that** the conductive tracks and preferably the signal emitter, IC, antenna and any other components, are also composed of conductive polymers, that are printed in a defined pattern using a suitable printing technique, such as ink jet printing, on the substrate, such as a carrier or a compartment wall or a layer that is affixed to one of these.

10. Package according to claim 9, **characterised in that** the package is implemented in the form of a so-called blister pack and that the products are medication, whereby the defined pattern can be printed on a sealing foil, which blister pack consists of the carrier containing compartment openings, upon one side of which a compartment sheet, containing five-walled compartments, and upon the other the sealing foil, that covers the compartment openings in the carrier and upon which the defined pattern and the components are printed, can be affixed using contact glue or a dedicated laminating process.

11. Package according to claim 9 or 10, **characterised in that** the at least one signal emitter comprises a capacitor, comprising at least two layers of polymers, that in the event of deformation or breakage, emits a current signal with a specific magnitude and frequency.

12. Package according to one of the claims 9 to 11 , **characterised in that** on the compartment wall opposite the sealing foil, a pattern in the form of a printed circuit can be printed, so that when this compartment wall is pressed in, this can be detected.

13. Package according to one of the claims 9 to 12, **characterized in that** by measuring and monitoring an extraction of a correct medication at a correct time, it is possible for observers to improve supervision of a therapy compliance of a patient, immediately or at a later stage.
